# EUROPEAN PATENT APPLICATION

(11) **EP 4 807 894 A1**
(43) Date of publication of application: **16.09.2026**
(21) Application number: 26162143.7
(22) Date of filing: 04.03.2026
(51) Int. Cl.: H01Q 1/02, H01Q 1/24, H04B 1/036, H05K 7/00, G06F 1/20

(54) **MODULAR ELECTRONIC DEVICE**

(30) Priority: 11.03.2025 TW 114108926
(71) Applicant: Arcadyan Technology Corporation, Hsinchu City 30071 (TW)
(72) Inventor: CHEN, Sheng-Chung, 30071 Hsinchu City (TW); LIU, Ching-Chang, 30071 Hsinchu City (TW); YANG, Chun-Kai, 30071 Hsinchu City (TW); LIOU, Te-Hsun, 30071 Hsinchu City (TW); TSAI, Ming-Hsun, 30071 Hsinchu City (TW)
(74) Representative: Krauns, Christian

(57) **Abstract**

A modular electronic device is provided. The modular electronic device includes a circuit-board assembly module, an antenna module, and a fan module. The circuit-board assembly module includes a frame, a heat-dissipation device, a circuit board, and a first signal-connection element. The heat-dissipation device and the circuit board are disposed on the frame, and the first signal-connection element is disposed on the circuit board. The antenna module is detachably disposed on a first side of the circuit-board assembly module, and the circuit board is electrically connected to the antenna module through the first signal-connection element. The fan module is detachably disposed on a second side of the circuit-board assembly module. The fan module is configured to provide an airflow, and the airflow passes from the second side through the circuit-board assembly module toward the first side.

## Description

### Field of the Invention

The invention relates in general to an electronic device, and more particularly to a modular electronic device.

### Description of the Related Art

In the present era, technological development advances rapidly, the computing capability of electronic devices increases and the signal-processing capability of electronic devices also becomes increasingly improved. In particular, the evolution of broadband networks and multimedia services causes the complexity of electronic devices to continuously increase.

In order to accelerate the development of electronic devices, the concept of modular design is introduced. Among the designs, how to rapidly install various modules together and allow one of the modules to be individually removed without affecting the structural design of other modules is of significant importance.

### SUMMARY OF THE INVENTION

The present invention relates to a modular electronic device that allows one of the printed circuit boards to be flexibly installed or individually removed without affecting the structural design of other printed circuit boards and the antenna module.

According to one aspect of the present invention, a modular electronic device is provided. The modular electronic device includes a circuit-board assembly module, an antenna module, and a fan module. The circuit-board assembly module includes a frame, a first heat-dissipation device, a circuit board, and a first signal-connection element. The first heat-dissipation device and the circuit board are disposed on the frame, and the first signal-connection element is disposed on the circuit board. The antenna module is detachably disposed on a first side of the circuit-board assembly module, and the circuit board is electrically connected to the antenna module through the first signal-connection element. The fan module is detachably disposed on a second side of the circuit-board assembly module. The fan module is configured to provide an airflow, and the airflow passes from the second side through the circuit-board assembly module toward the first side.

According to one aspect of the present invention, a method for assembling a modular electronic device includes the following steps. a circuit-board assembly module is provided, wherein the circuit-board assembly module comprises a frame, a first heat-dissipation device, a circuit board, and a first signal-connection element, the first heat-dissipation device and the circuit board being disposed on the frame, and the first signal-connection element being disposed on the circuit board. An antenna module is detachably disposed on a first side of the circuit-board assembly module, wherein the circuit board is electrically connected to the antenna module through the first signal-connection element. A fan module is detachably disposed on a second side of the circuit-board assembly module, wherein the fan module is able to provide an airflow, and the airflow passing from the second side through the circuit-board assembly module toward the first side.

The above and other aspects of the invention will become better understood with regard to the following detailed description of the preferred but non-limiting embodiment(s). The following description is made with reference to the accompanying drawings.

### BRIEF DESCRIPTION OF THE DRAWINGS

FIG. 1 illustrates a perspective view of a modular electronic device according to an embodiment of the present invention.
FIG. 2 illustrates an exploded view of the modular electronic device of FIG. 1.
FIG. 3 illustrates another perspective view of the modular electronic device of FIG. 1.
FIG. 4 illustrates an exterior schematic view of the circuit-board assembly module.
FIG. 5 illustrates an exploded view of the circuit-board assembly module of FIG. 4.
FIG. 6 illustrates a partially enlarged view of a latching device located above the frame of FIG. 4.
FIGS. 7 to 9 respectively illustrate schematic views of a latch member used for retaining the circuit board.

### DETAILED DESCRIPTION OF THE INVENTION

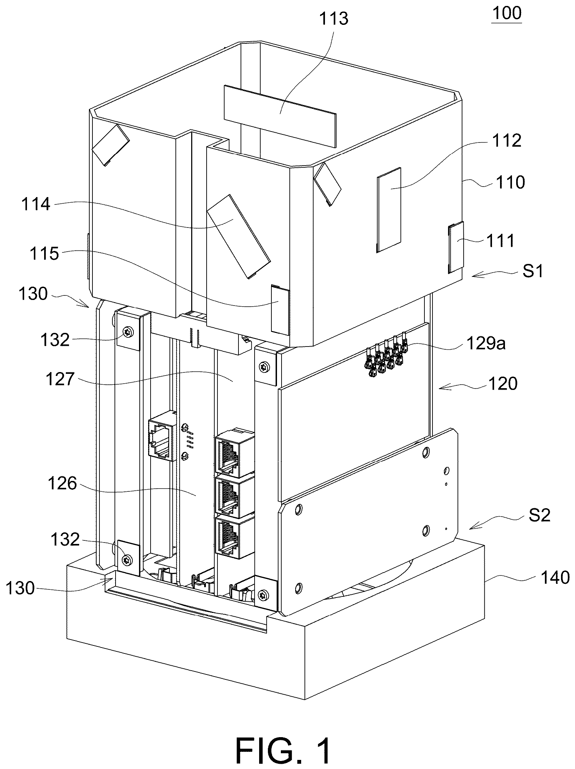

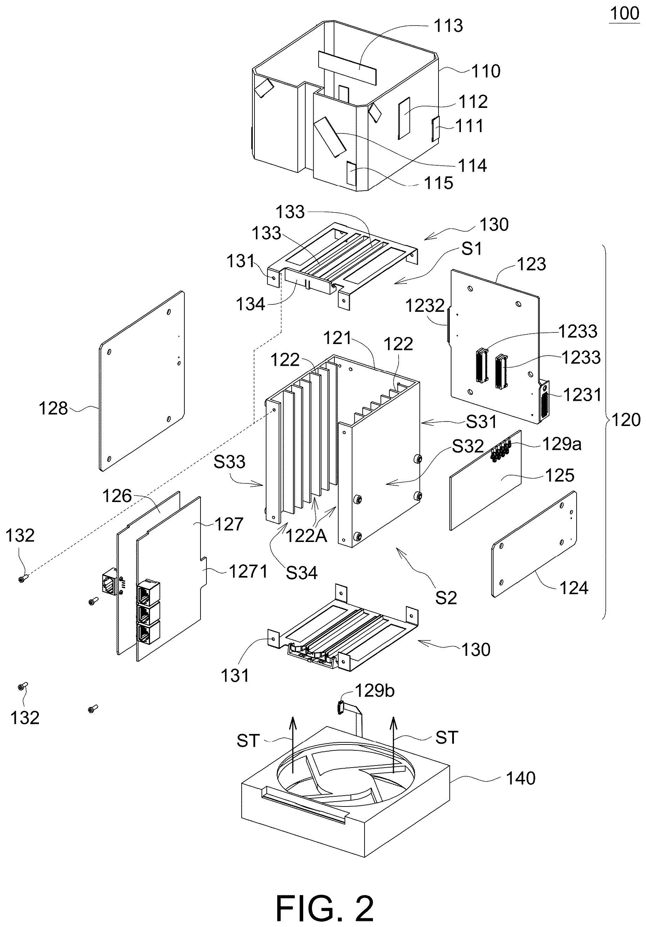

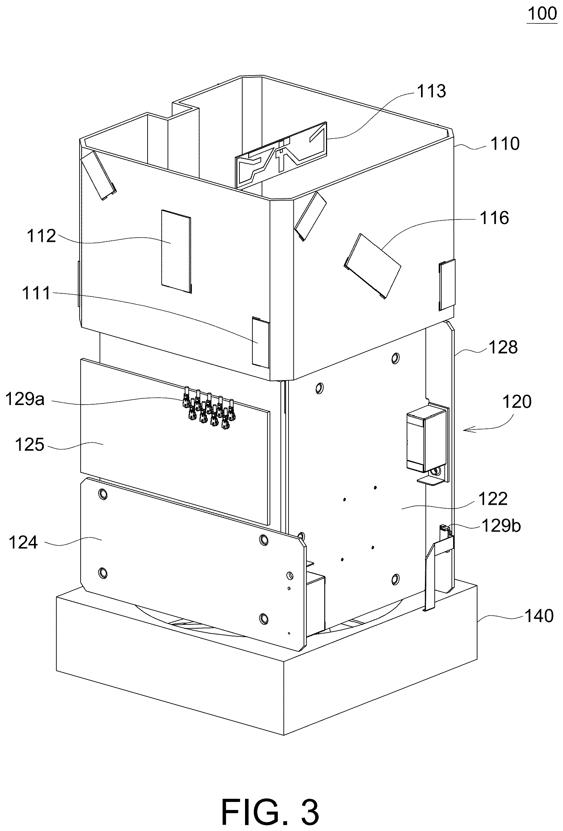

Referring to FIG. 1 to FIG. 3, FIG. 1 illustrates a perspective view of a modular electronic device 100 according to an embodiment of the present invention, FIG. 2 illustrates an exploded view of the modular electronic device 100 of FIG. 1, and FIG. 3 illustrates another perspective view of the modular electronic device 100 of FIG. 1. The modular electronic device 100 includes, from top to bottom in a stacked manner, an antenna module 110, a circuit-board assembly module 120, and a fan module 140. The antenna module 110 is disposed on a first side S1 of the circuit-board assembly module 120, and the fan module 140 is disposed on a second side S2 of the circuit-board assembly module 120. The first side S1 and the second side S2 are located on opposite sides of the circuit-board assembly module 120. In other embodiments, the first side S1 and the second side S2 may be located on non-opposite sides of the circuit-board assembly module 120, and the relative positions of the antenna module 110, the circuit-board assembly module 120 and the fan module 140 may be adjusted as required.

As illustrated in FIGS. 1 and 3, the antenna module 110 includes multiple antennas 111-116, and each of the antennas 111-116 has one frequency band. Generally, in a Universal Mobile Telecommunications System (UMTS), the main operating frequency band of the antenna module 110 may be within a range from 1920 MHz to 2170 MHz. In a Wi-Fi system according to the IEEE 802.11 standard, the main operating frequency band of the antenna module 110 for 802.11bg may be within a range from 2.40 GHz to 2.50 GHz. The main operating frequency band of the antenna module 110 for LTE may be within a range from 1.71 GHz to 2.70 GHz. The main operating frequency band of the antenna module 110 for 802.11a may be within a range from 5.15 GHz to 5.85 GHz. In addition, in an ultra-wideband (UWB) system according to the IEEE 802.15.3a standard, the main operating frequency band of the antenna module 110 may be within a range from 3.1 GHz to 4.8 GHz. Therefore, the antenna module 110 of the present embodiment can support multiple frequency bands such as 4G/LTE + 5G/Sub-6G + Wi-Fi to constitute a multi-band antenna module 110 for the modular electronic device 100.

Referring to FIG. 2, the circuit-board assembly module 120 may include, but is not limited to, a frame 121, a set of heat-dissipation devices 122, a backboard 123, multiple circuit boards 124-128, a first signal-connection element 129a, and a second signal-connection element 129b. The frame 121 serves as a structural body for installing the set of heat-dissipation devices 122 and the circuit boards 124-128 inside or outside the modular electronic device 100. The material of the frame 121 may be metal or a rigid material. The heat-dissipation devices 122 may be a structure formed by multiple heat-dissipation fins or heat pipes, or may be integrally formed with the frame 121. The heat-dissipation devices 122 are located on an inner side of the frame 121, and the material of the heat-dissipation devices 122 may be a copper plate or an aluminum plate. The heat-dissipation devices 122 absorb waste heat generated by electronic components on the circuit boards 124-128 and conducts the waste heat to the exterior of the circuit-board assembly module 120. The fan module 140 is disposed on the second side S2 of the frame 121, and the fan module 140 can generate an airflow ST to carry away the heat generated by the circuit boards 124-128 and the heat absorbed by the heat-dissipation devices 122 through convection. The number of sets of heat-dissipation devices 122 may include, but is not limited to, two. The number of circuit boards 124-128 may include, but is not limited to, five.

Referring to FIG. 2, the backboard 123 is disposed, for example, on a rear side S31 of the frame 121. Two circuit boards 124-125 are disposed on a right side S32 of the frame 121. One circuit board 128 is disposed on a left side S33 of the frame 121. Two pluggable circuit boards 126-127 are disposed on a front side S34 of the frame 121. Two electrical connectors 1231 and 1232 are respectively disposed on left and right sides of the backboard 123, such that the circuit board 128 can be electrically connected to the backboard 123 through the electrical connector 1232 on the left side, and the circuit board 124 can be electrically connected to the backboard 123 through the electrical connector 1231 on the right side. One of the circuit boards 124-128 may be flexibly installed or individually removed without affecting the structural design of the other circuit boards and the antenna module 110.

Referring to FIG. 2, the backboard 123 is disposed on the rear side S31 of the frame 121, and the installation direction of the backboard 123 is substantially perpendicular to the installation direction of the pluggable circuit boards 126 and 127. Multiple expansion slots 1233 may be disposed on the backboard 123. The expansion slots 1233 may be card-edge-connector slots (commonly known as "gold-finger" slots). The expansion slots 1233 can be electrically connected to card-edge connectors 1271 (only one is shown) of the pluggable circuit boards 126 and 127, such that the backboard 123 and the pluggable circuit boards 126 and 127 are electrically connected. The number of expansion slots 1233 may include, but is not limited to, two.

In one embodiment, first and second heat-dissipation devices 122 and the pluggable circuit boards 126 and 127 located on the front side S34 are disposed in a parallel to form one or more airflow channels 122A. The airflow channels 122A are substantially parallel to the stacking direction (i.e., the vertical direction) of the antenna module 110, the circuit-board assembly module 120, and the fan module 140, such that the airflow ST can pass upward through the airflow channels 122A between the first and second heat-dissipation devices 122 and the pluggable circuit boards 126 and 127 to carry away waste heat.

Referring to FIG. 2, the antenna module 110 is detachably disposed on the first side S1 of the circuit-board assembly module 120, and the fan module 140 is detachably disposed on the second side S2 of the circuit-board assembly module 120. In one embodiment, the antenna module 110 is electrically connected to the circuit board 125 through the first signal-connection element 129a disposed on the circuit board 125. The antenna module 110 is used for transmitting or receiving radio-frequency signals. For example, electronic signals may be converted into radio-frequency signals, or radio-frequency signals may be converted into electronic signals, through a signal-conversion element (not illustrated) disposed on the circuit board 124 for data transmission.

Referring to FIG. 2, the fan module 140 may be electrically connected to the circuit board 128 through the second signal-connection element 129b (also refer to FIG. 3) disposed on the circuit board 128, such that the fan module 140 is driven by electrical power to rotate. For example, when an internal temperature of the modular electronic device 100 is detected to exceed a threshold, a driver (not illustrated) can drive the fan module 140 to rotate and generate a cooling airflow ST to reduce the internal temperature of the modular electronic device 100 to a predetermined value (for example, less than or equal to the set threshold).

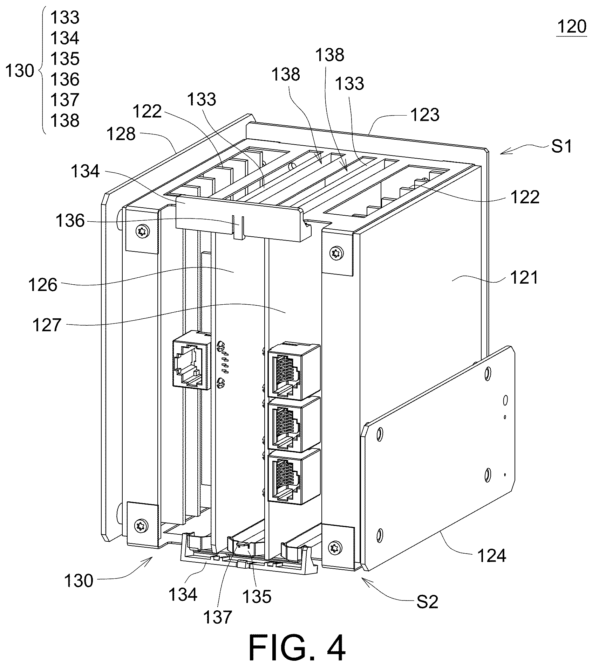

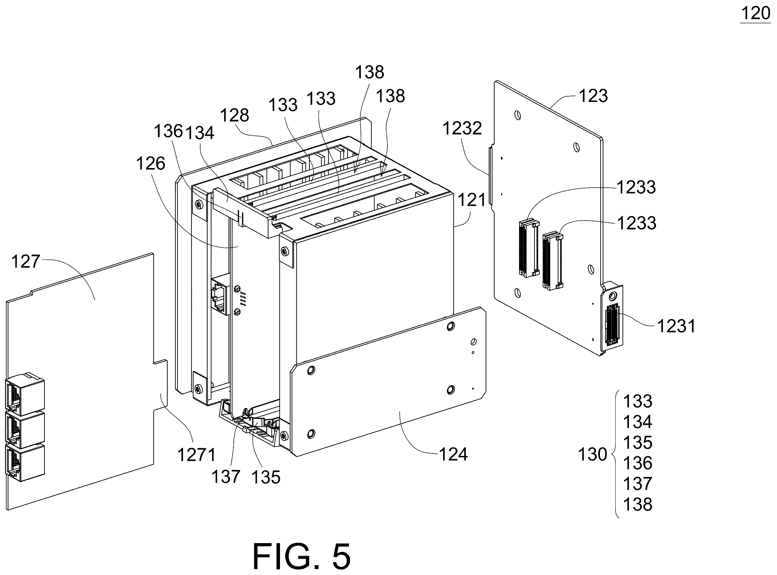

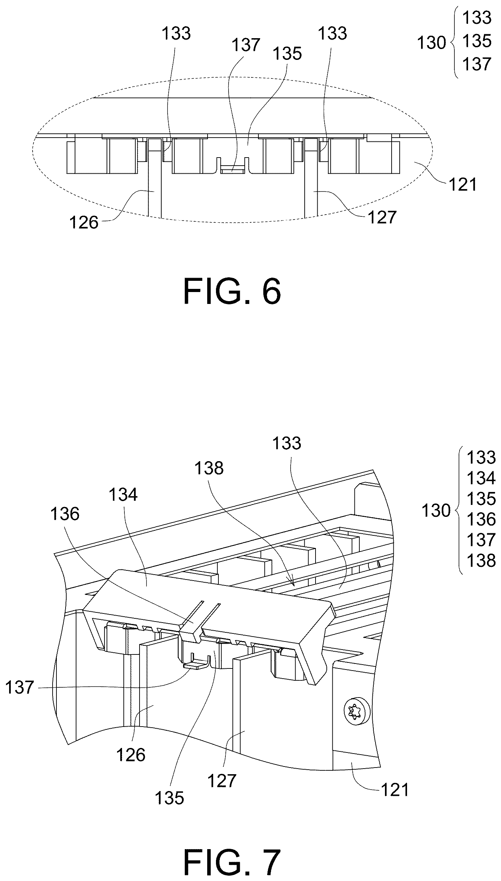

Referring to FIGS. 4 to 6, FIG. 4 illustrates an exterior schematic view of the circuit-board assembly module 120, FIG. 5 illustrates an exploded view of the circuit-board assembly module 120 of FIG. 4, and FIG. 6 illustrates a partially enlarged view of a latching device 130 located above the frame 121 of FIG. 4. In one embodiment, in order to fix the pluggable circuit boards 126 and 127 within the frame 121, the circuit-board assembly module 120 may include a set of latching devices 130. The set of latching devices 130 is disposed on an upper side or a lower side of the frame 121, or respectively on both the upper side and the lower side (i.e., the first side S1 and the second side S2 as illustrated). In one embodiment, the latching devices 130 may include, but is not limited to, sliding rails 133, latch members 134, counter members 135, elastic arms 136, limiting arms 137, and airflow channels 138.

Referring to FIG. 6, a latching device 130 is disposed on an upper side of the frame 121. For ease of illustration, the latch member 134 is omitted in FIG. 6, and only the counter member 135 and the limiting arm 137 are illustrated. The structure of the latching devices 130 disposed on the upper side and the lower side may be the same or different. For example, the latching devices 130 disposed on both the upper side and the lower side may each be provided with a latch member 134. In one embodiment, the latching device 130 includes multiple locking holes 131 (refer to FIG. 2) and multiple locking members 132 (refer to FIG. 2) corresponding to the locking holes 131. The locking members 132 can pass through the locking holes 131 to fix the latching devices 130 to the upper side and/or the lower side of the frame 121.

In addition, referring to FIG. 5, each of the latching devices 130 may include multiple sliding rails 133, and the number of sliding rails 133 may include, but is not limited to, two. An airflow channel 138 is formed between the sliding rails 133, such that the airflow ST generated by the fan module 140 (see FIG. 2) can pass vertically through the airflow channel 138. The pluggable circuit boards 126 and 127 can be arranged in the same direction along a lengthwise direction of the sliding rails 133 and can be removably installed in one of the sliding rails 133, such that the pluggable circuit boards 126 and 127 are positioned within the frame 121 by the limiting function of the sliding rails 133. In one embodiment, when the pluggable circuit boards 126 and 127 are inserted along the lengthwise direction of the sliding rails 133 to a certain point, the card-edge connectors 1271 of the pluggable circuit boards 126 and 127 may be electrically connected to the expansion slots 1233 on the backboard 123.

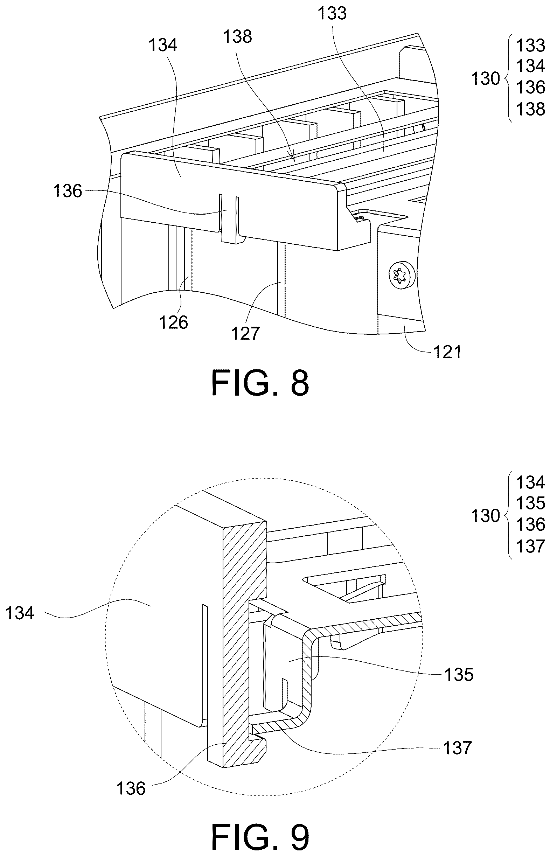

Next, referring to FIGS. 7 to 9, FIGS. 7 to 9 respectively illustrate schematic views of a latch member 134 used for retaining the pluggable circuit boards 126 and 127. The latch member 134 is used for retaining the pluggable circuit boards 126 and 127. The latch member 134 is pivotally disposed on one side of one of the sliding rails 133, for example, a front side (i.e., the front side S34 of FIG. 2) of the sliding rails 133, which is the side from which the pluggable circuit boards 126 and 127 are inserted or removed along the lengthwise direction of the sliding rails 133. The latch member 134 may include an elastic arm 136 disposed at a central portion of the latch member 134. The counter member 135 may include a limiting arm 137 disposed on a side opposite to the elastic arm 136. When the latch member 134 rotates relative to the counter member 135 to a latching position (as shown in FIGS. 8 and 9), the elastic arm 136 and the limiting arm 137 engage with each other such that the pluggable circuit boards 126 and 127 are retained by the latch member 134 and cannot be removed. When the latch member 134 rotates relative to the counter member 135 to a position away from the latching position (as shown in FIG. 7), the elastic arm 136 and the limiting arm 137 separate from each other, such that the pluggable circuit boards 126 and 127 can be removed from the frame 121 and/or inserted into the frame 121. However, the present invention is not limited to retaining the pluggable circuit boards 126 and 127 in the above-described manner, and other latching mechanisms may also be used to retain the pluggable circuit boards 126 and 127.

According to the modular electronic device of the above embodiment of the present invention, one of the circuit boards can be flexibly installed or individually removed without affecting the structural design of the other circuit boards and the antenna module. In addition, the modular electronic device of the present embodiment adopts a multi-band antenna module, can achieve multi-band operation through printed antennas, and utilizes the fan module to enhance cooling airflow and heat dissipation to remove waste heat generated by the modular electronic device.

While the invention has been described by way of example and in terms of the preferred embodiment(s), it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A modular electronic device (100), comprising:
a circuit-board assembly module (120), comprising a frame (121), a first heat-dissipation device (122), a circuit board (124-128), and a first signal-connection element (129a), the first heat-dissipation device (122) and the circuit board (124-128) being disposed on the frame (121), and the first signal-connection element (129a) being disposed on the circuit board (124-128);
an antenna module (110) detachably disposed on a first side (S1) of the circuit-board assembly module (120), wherein the circuit board (124-128) is electrically connected to the antenna module (110) through the first signal-connection element (129a); and
a fan module (140) detachably disposed on a second side (S2) of the circuit-board assembly module (120), the fan module (140) being configured to provide an airflow (ST), and the airflow passing from the second side (S2) through the circuit-board assembly module (120) toward the first side (S1).

2. The modular electronic device of claim 1, wherein the circuit-board assembly module (120) further comprises a backboard (123) and an expansion slot (1233), the expansion slot (1233) being disposed on the backboard (123), and the expansion slot (1233) being configured to electrically connect with the circuit board (124-128).

3. The modular electronic device of claim 1 or 2, wherein the circuit-board assembly module (120) further comprises a latching device (130) disposed on an upper side of the frame (121), a lower side of the frame (121), or both the upper side and the lower side, and the latching device (130) is configured to fix the circuit board (124-128).

4. The modular electronic device of claim 3, wherein the latching device (130) comprises a plurality of sliding rails (133), an airflow channel (138) is formed between the sliding rails (133), and the circuit board (124-128) is removably disposed in one of the sliding rails.

5. The modular electronic device of claim 4, wherein the latching device further comprises a latch member (134) pivotally disposed on one side of the sliding rails (133), and the latch member (134) is configured to retain the circuit board (124-128).

6. The modular electronic device of claim 5, wherein the latching device (130) further comprises a counter member (135) disposed on a side opposite to the latch member (134), and the latch member (134) is rotatable relative to the counter member (135).

7. The modular electronic device of anyone of the claims 1 to 6, wherein the first heat-dissipation device (122) is disposed in a manner parallel to the circuit board (124-128).

8. The modular electronic device of anyone of the claims 1 to 7, wherein the fan module (140), the circuit-board assembly module (120), and the antenna module (110) are stacked in sequence.

9. The modular electronic device of anyone of the claims 1 to 8, wherein the circuit-board assembly module (120) further comprises a second signal-connection element (129b) disposed on the circuit board (128), and the circuit board (128) is electrically connected to the fan module (140) through the second signal-connection element (129b).

10. The modular electronic device of anyone of the claims 1 to 9, wherein the first heat-dissipation device (122) comprises an aluminum plate or a copper plate, and the first heat-dissipation device (122) is disposed inside the frame (121).

11. The modular electronic device of claim 7, wherein the circuit-board assembly module (120) further comprises a second heat-dissipation device (122) disposed on the frame (121), and the second heat-dissipation device (122) and the first heat-dissipation device (122) are separated by the circuit board (124-128).

12. The modular electronic device of claim 11, wherein the second heat-dissipation device (122) is disposed in a manner parallel to the circuit board (124-128).

13. A method for assembling a modular electronic device (100), comprising:
providing a circuit-board assembly module (120), wherein the circuit-board assembly module (120) comprises a frame (121), a first heat-dissipation device (122), a circuit board (124-128), and a first signal-connection element (129a), the first heat-dissipation device (122) and the circuit board (124-128) being disposed on the frame (121), and the first signal-connection element (129a) being disposed on the circuit board (124-128);
disposing an antenna module (110) detachably on a first side (S1) of the circuit-board assembly module (120), wherein the circuit board (124-128) is electrically connected to the antenna module (110) through the first signal-connection element (129a); and
disposing a fan module (140) detachably on a second side (S2) of the circuit-board assembly module (120),
wherein the fan module (140) is able to provide an airflow (ST), and the airflow (ST) passing from the second side (S2) through the circuit-board assembly module (120) toward the first side (S1).
